# EUROPEAN PATENT APPLICATION

(11) **EP 4 826 425 A1**
(43) Date of publication of application: **21.10.2026**
(21) Application number: 24910554.5
(22) Date of filing: 02.12.2024
(51) Int. Cl.: G02B 6/42

(54) **OPTICAL CAGE, COMMUNICATION APPARATUS AND THERMAL CONDUCTION DEVICE**

(30) Priority: 29.12.2023 CN 202311870501
(71) Applicant: Huawei Technologies Co., Ltd., Shenzhen, Guangdong 518129 (CN)
(72) Inventor: FENG, Yun, Shenzhen, Guangdong 518129 (CN); SU, Wenjie, Shenzhen, Guangdong 518129 (CN); DENG, Shuwen, Shenzhen, Guangdong 518129 (CN)
(74) Representative: Maiwald GmbH
(86) International application number: PCT/CN2024/136220
(87) International publication number: WO 2025/139622

(57) **Abstract**

An optical cage, a communication device, and a heat conduction apparatus are provided, relating to the field of communication technologies. The optical cage includes an insertion portion and an accommodating portion that are adjoining each other along a first direction. The insertion portion includes a first insertion wall and a second insertion wall that are arranged opposite to each other, the first insertion wall is located on a side of the second insertion wall in a second direction, a socket that extends along the first direction is provided between the first insertion wall and the second insertion wall, and the socket is configured to receive an optical module. The accommodating portion includes two side walls that are arranged opposite to each other along a third direction, an accommodating cavity for accommodating the optical module is provided between the two side walls, the socket and the accommodating cavity are in communication with each other along the first direction, first edges of the two side walls along the second direction cooperatively define an opening of the accommodating cavity on a side along the second direction, and the first edges are configured to be in contact with the heat conduction apparatus to provide support. Along the second direction, a height of at least a part of the first edges is less than a height of an outer wall surface of the first insertion wall. The optical cage provided in this application can reduce the overall height of the optical cage and the heat conduction apparatus when the heat conduction apparatus is mounted on the optical cage.

## Description

This application claims priority to Chinese Patent Application No. 202311870501.0, filed with the China National Intellectual Property Administration on December 29, 2023 and entitled "OPTICAL CAGE, COMMUNICATION DEVICE, AND HEAT CONDUCTION APPARATUS", which is incorporated herein by reference in its entirety.

### TECHNICAL FIELD

This application relates to the field of communication device technologies, and in particular, to an optical cage, a communication device, and a heat conduction apparatus.

### BACKGROUND

Optical fiber communication technology has advantages such as high data rates, long-distance transmission, and anti-interference, and is widely used in communication devices such as optical transmission devices, switches, and routers. Currently, a communication device is equipped with an optical cage, which includes an optical module interface. An optical module is pluggably arranged on an interface of the optical cage, and signal connection is implemented between communication devices by using the optical module.

With the continuous development and upgrading of 4G and 5G networks, a plurality of optical cages are arranged in a communication device as optical modules are deployed more densely. Heat sinks are arranged on the top of the optical cages. The current stacked design of heat sinks and optical cages requires further optimization. Under the existing arrangement, the overall height of the optical cage and the heat sink is relatively large, resulting in an increased overall volume of the communication device and complicating the layout of other internal components. The layout of the optical cage and the heat sink has become a problem to be resolved, particularly in the context of achieving high integration within limited space.

### SUMMARY

This application provides an optical cage, a communication device, and a heat conduction apparatus, to reduce the overall height of the optical cage and the heat conduction apparatus when the heat conduction apparatus is mounted on the optical cage.

According to a first aspect, this application provides an optical cage, including an insertion portion and an accommodating portion that are adjoining each other along a first direction. The insertion portion includes a first insertion wall and a second insertion wall that are arranged opposite to each other, and further includes a third insertion wall and a fourth insertion wall that are arranged opposite to each other. The first insertion wall is located on a side of the second insertion wall in a second direction. The first insertion wall, the third insertion wall, the second insertion wall, and the fourth insertion wall are successively connected and cooperatively define a socket penetrating along the first direction. The socket is configured to receive an optical module. The accommodating portion includes two side walls that are arranged opposite to each other along a third direction. An accommodating cavity for accommodating the optical module is provided between the two side walls. The socket and the accommodating cavity are in communication with each other along the first direction. First edges of the two side walls along the second direction cooperatively define an opening of the accommodating cavity on a side along the second direction. The first edges are configured to be in contact with a heat conduction apparatus to provide support. Along the second direction, a height of at least a part of the first edges is less than a height of an outer wall surface of the first insertion wall.

The optical cage provided in this application may receive the optical module, and an opening used to allow placement of the heat conduction apparatus is provided at the accommodating portion of the optical cage. In the second direction, a height of the first edges of the opening is less than a height of the first insertion wall. When the heat conduction apparatus is placed on the first edges, the overall height of the heat conduction apparatus and the optical cage is reduced. Especially when the communication device is equipped with a plurality of optical cages, the heat conduction apparatus is arranged on each of the plurality of optical cages. Due to a decrease in the overall height of a single optical cage and the heat conduction apparatus, an overall height of the plurality of optical cages is significantly reduced, so that more optical modules can be arranged within limited space. When the same quantity of optical modules are arranged, a height of the communication device is reduced, a space headroom is increased, and a fin height of the heat conduction apparatus is increased, which is more conducive to heat conduction. In addition, the optical module in direct contact with the heat conduction apparatus, so that a heat dissipation effect is significantly improved, and stable operation of a system is ensured.

In a possible implementation, the accommodating portion further includes a support plate, the first insertion wall, the opening, and the support plate are successively arranged, and a second edge of the support plate on a side close to the first insertion wall is a part of a side edge of the opening. At least a part of an outer wall surface of the support plate on a side in the second direction is a first wall surface. The first wall surface is configured to be in contact with the heat conduction apparatus to provide support. Along the second direction, a height of the first wall surface is less than the height of the outer wall surface of the first insertion wall. The support plate is configured to support the heat conduction apparatus. A height of the first wall surface of the support plate along the second direction is less than the outer wall surface of the first insertion wall, so that the overall height of the optical cage and the heat conduction apparatus is reduced while providing support for the heat conduction apparatus.

In a possible implementation, the outer wall surface of the support plate on the side in the second direction is the first wall surface, the first wall surface is parallel to the outer wall surface of the first insertion wall, and the first wall surface is configured to be in contact with the heat conduction apparatus to provide support. Along the second direction, the height of the first wall surface is less than the height of the outer wall surface of the first insertion wall. In the second direction, an overall height of the support plate is less than the height of the outer wall surface of the first insertion wall, a support member can support the heat conduction apparatus, and when the heat conduction apparatus is mounted on the optical cage, the overall height of the heat conduction apparatus and the optical cage is reduced.

In a possible implementation, the support plate includes a first portion and a second portion that are adjoining each other along the third direction. The first wall surface is an outer wall surface of the first portion along the second direction, an inner wall surface of the first portion on a side opposite to the second direction is a second wall surface, an inner wall surface of the second portion on a side opposite to the second direction is a third wall surface, and the third wall surface is located on a side of the second wall surface along the second direction to form a step structure. Therefore, the support member can match different models of optical modules, for example, match a QSFPDD optical module.

In a possible implementation, an outer wall surface of the second portion on a side along the second direction is a fourth wall surface, the fourth wall surface is located on a side of the first wall surface along the second direction, and the second portion protrudes relative to the first portion along the second direction. The support plate may be formed by bending an integral plate, and a structure where the first portion is lower than the second portion is presented on an outer side. A structure such as a heat pipe of the heat conduction apparatus may be arranged on a sunken part of the first portion, to improve heat conduction efficiency of the heat conduction apparatus.

In a possible implementation, along the second direction, the fourth wall surface is coplanar with the outer wall surface of the first insertion wall along the second direction. When an optical module of a QSFPDD model is inserted into the optical cage, the optical module of the QSFPDD model is relatively long, and the fourth wall surface is coplanar with the outer wall surface of the first insertion wall along the second direction, to ensure that the optical module of the QSFPDD model can be inserted into the optical cage.

In a possible implementation, a width of the first wall surface along the third direction is greater than 7 millimeters. The first wall surface provides a space for arranging the heat pipe inside the heat conduction apparatus, and can accommodate a heat conduction apparatus structure with the heat pipe added inside. The heat pipe arranged inside the heat conduction apparatus can improve heat dissipation efficiency of the heat conduction apparatus, and bring a better heat dissipation effect for heat dissipation of the optical module.

In a possible implementation, the support plate is provided with a wave-absorbing structure on a side opposite to the second direction, and the wave-absorbing structure is configured to absorb electromagnetic radiation. The wave-absorbing structure may be attached to the side of the support plate opposite to the second direction. The wave-absorbing structure can absorb a radiated electromagnetic wave generated by an electromagnetic compatibility device, reduce electromagnetic interference, and prevent the radiated electromagnetic wave of the electromagnetic compatibility device from affecting a function of another communication device.

In a possible implementation, a thickness of the second edge along the second direction ranges from 0.35 millimeters to 0.5 millimeters. The thickness of the second edge along the second direction ranges from 0.35 millimeters to 0.5 millimeters, so that a side surface of the second edge on a side opposite to the first direction can better abut against the optical module, and limits a position where the optical module is inserted into the optical cage along the first direction, to ensure that the optical module and a connector can be precisely positioned and connected.

In a possible implementation, a first protrusion is provided on at least one of the side walls, the first protrusion protrudes from the side wall away from the accommodating cavity, the first protrusion has a support surface on a side along the second direction, and the support surface is configured to support the heat conduction apparatus. The support surface is formed on a side of the first protrusion along the second direction. A width of the support surface along the third direction may be greater than a width of the first edges along the third direction, and the support surface can assist two side walls in supporting the heat conduction apparatus, to provide a larger support area for the heat conduction apparatus.

In a possible implementation, along the second direction, a height of the support surface is less than the height of the outer wall surface of the first insertion wall. The support surface is located between the outer wall surface of the first insertion wall and the outer wall surface of the second insertion wall. The support surface not only can support the heat conduction apparatus, but also can ensure that the overall height of the heat conduction apparatus and the optical cage is reduced when the heat conduction apparatus is mounted on the optical cage.

In a possible implementation, the side wall is provided with a limiting structure on a side in the second direction, and a part of the limiting structure extends into the accommodating cavity and is configured to abut against the optical module along the first direction. The part of the limiting structure that extends into the accommodating cavity can abut against the optical module along the first direction, to limit an insertion depth of the optical module in the optical cage, and limit the position where the optical module is inserted into the optical cage along the first direction, so that the optical module and the connector can be precisely positioned and connected.

In a possible implementation, the limiting structure includes a second protrusion extending from the first edges to the second direction, and a free end of the second protrusion is bent toward a side close to the accommodating cavity. The free end of the second protrusion is bent toward the side close to the accommodating cavity to form a C-like structure. The structure can match a groove on the optical module. When the optical module is inserted into the optical cage, the second protrusion may be inserted into the groove on the optical module, to limit the optical module and ensure an accurate insertion position of the optical module in the optical cage, thereby improving stability of connection between the optical module and the optical cage.

According to a second aspect, this application provides a communication device, including a heat conduction apparatus and the optical cage according to any one of the implementations. At least a part of the heat conduction apparatus is located on a side of the outer wall surface of the first insertion wall opposite to the second direction. The heat conduction apparatus covers the opening, and is in contact with and connected to the first edges of the optical cage.

The communication device provided in this application is installed with the optical cage. The heat conduction apparatus comes into contact with the opening of the optical cage when being mounted on the optical cage. The first edges of the opening sink relative to the outer wall surface of the first insertion wall, so that an overall thickness of the optical cage and the heat conduction apparatus can be reduced. Especially when a plurality of optical cages are arranged in the communication device, a plurality of optical modules are mounted in the optical cages in one-to-one correspondence, so that an overall width or height of the communication device provided with the plurality of optical cages is effectively reduced, and then more optical cages can be arranged within limited space. When the same quantity of optical modules are arranged, the height of the communication device can also be reduced, a space headroom is increased, and a fin height of the heat conduction apparatus is increased, which is more conducive to heat conduction. In addition, the heat conduction apparatus may be directly in contact with the optical module, thereby effectively improving a heat dissipation effect.

In a possible implementation, the communication device further includes an elastic member. The elastic member is connected to the optical cage and the heat conduction apparatus, and the optical cage is detachably connected to the heat conduction apparatus. Along the second direction, the heat conduction apparatus moves relative to the optical cage, and the elastic member is configured to apply, to the heat conduction apparatus opposite to the second direction, an elastic force toward a side of the optical cage.

The optical module may come into contact with a side of the heat conduction apparatus toward the opening when being inserted into the optical cage, and allow the heat conduction apparatus to move in the second direction. The elastic member may apply an elastic force to the heat conduction apparatus opposite to the second direction, so that the heat conduction apparatus moves toward the side of the optical cage. The elastic member can limit the heat conduction apparatus in the second direction, so as to ensure that the heat conduction apparatus is preferably connected to the optical cage, and further preferably attached to the optical module, thereby improving the heat dissipation effect.

In a possible implementation, the communication device further includes a circuit board. The optical cage is fastened to the circuit board, and at least one optical cage is mounted on the circuit board.

In a possible implementation, the communication device further includes a connector. The connector is located within the optical cage, the connector is electrically connected to the circuit board, and the connector is configured to be electrically connected to the optical module.

In a possible implementation, the communication device includes a sub-rack. A mounting cavity is arranged on the sub-rack, and the circuit board is securely mounted within the mounting cavity.

In a possible implementation, at least one mounting cavity is provided, and at least one circuit board is arranged in a single mounting cavity.

According to a third aspect, this application provides a heat conduction apparatus, including a heat conduction surface. The heat conduction surface is of a planar structure, and the heat conduction surface is configured to contact a first edge of an optical cage and an optical module. The heat conduction apparatus performs heat exchange with the optical module through the heat conduction surface, to achieve an effect of heat dissipation for the optical module. The heat conduction surface may be directly in contact with the optical module, and a part of the heat conduction apparatus in contact with the optical module has a small thickness, which can better dissipate heat for the optical module and improve a heat dissipation effect.

### BRIEF DESCRIPTION OF DRAWINGS

FIG. 1 is a diagram of a structure of a communication device according to an implementation of this application;
FIG. 2 is a diagram of a structure of an optical cage according to an implementation of this application;
FIG. 3 is a side view of an optical cage according to an implementation of this application;
FIG. 4 is a top view of an optical cage according to an implementation of this application;
FIG. 5 is a diagram of a structure of an optical cage with a heat conduction apparatus placed thereon according to an implementation of this application;
FIG. 6 is a diagram of a structure of an optical cage with an optical module inserted therein according to an implementation of this application;
FIG. 7 is a cross-sectional view at A-A in FIG. 6 according to an implementation of this application;
FIG. 8 is a diagram of a structure of an optical cage according to another implementation of this application;
FIG. 9 is a cross-sectional view at B-B in FIG. 8 according to an implementation of this application;
FIG. 10 is a diagram of a structure of an optical cage with an optical module inserted therein according to another implementation of this application;
FIG. 11 is a cross-sectional view at C-C in FIG. 10 according to an implementation of this application;
FIG. 12 is a cross-sectional view at C-C in FIG. 10 according to an implementation of this application;
FIG. 13 is a diagram showing that a fourth wall surface is coplanar with an outer wall surface of a first insertion wall along a second direction according to an implementation of this application;
FIG. 14 is a diagram of a structure of a communication device according to another implementation of this application;
FIG. 15 is a diagram of a structure of a circuit board according to an implementation of this application; and
FIG. 16 is a diagram of a structure of a communication device according to another implementation of this application.

### DESCRIPTION OF EMBODIMENTS

Embodiments of this application are described below with reference to the accompanying drawings in embodiments of this application.

For ease of understanding, English abbreviations and related technical terms involved in embodiments of this application are first explained and described below.

It should be noted that the described embodiments are merely some embodiments rather than all embodiments of this application. All other embodiments obtained by a person of ordinary skill in the art based on embodiments of this application without creative efforts fall within the protection scope of this application.

Terms used in embodiments of this application are merely intended to describe specific embodiments but are not intended to limit this application. Singular forms of "a", "said", and "the" used in embodiments of this application and the appended claims are also intended to include plural forms, unless the context clearly indicates otherwise.

It should be understood that a term "and/or" in this specification is merely the same field for describing associated objects and indicates that three relationships may exist. For example, A and/or B may represent the following three cases: A exists alone, both A and B exist, and B exists alone. In addition, a character "/" in this specification generally indicates an "or" relationship between the associated objects.

It should be understood that terms such as "first" and "second" used in this application are merely for the purpose of distinguishing, and should not be construed as indicating or implying relative importance or order.

In the description of this application, orientation or position relationships indicated by terms such as "center", "up", "down", "front", "rear", "left", "right", "vertical", "horizontal", "top", "bottom", "inside", and "outside" are based on orientation or position relationships shown in the accompanying drawings, and are used only for ease and brevity of description of this application, rather than indicating or implying that the mentioned apparatus or element needs to have a particular orientation or needs to be constructed and operated in a particular orientation. Therefore, the terms should not be construed as a limitation on this application.

A phrase "within a range of xxx" used in this application, unless separately indicating that endpoint values are not included, shall by default include the endpoint values of the range. For example, "within a range of 1 to 5" indicates that values 1 and 5 are included.

In the description of this application, it should be noted that unless otherwise expressly specified and defined, terms such as "mount", "connect", and "connection" should be understood in a broad sense. For example, the connection may indicate a secure connection, a detachable connection, an abutting connection, or an integral connection. A person of ordinary skill in the art may understand specific meanings of the foregoing terms in this application according to specific conditions.

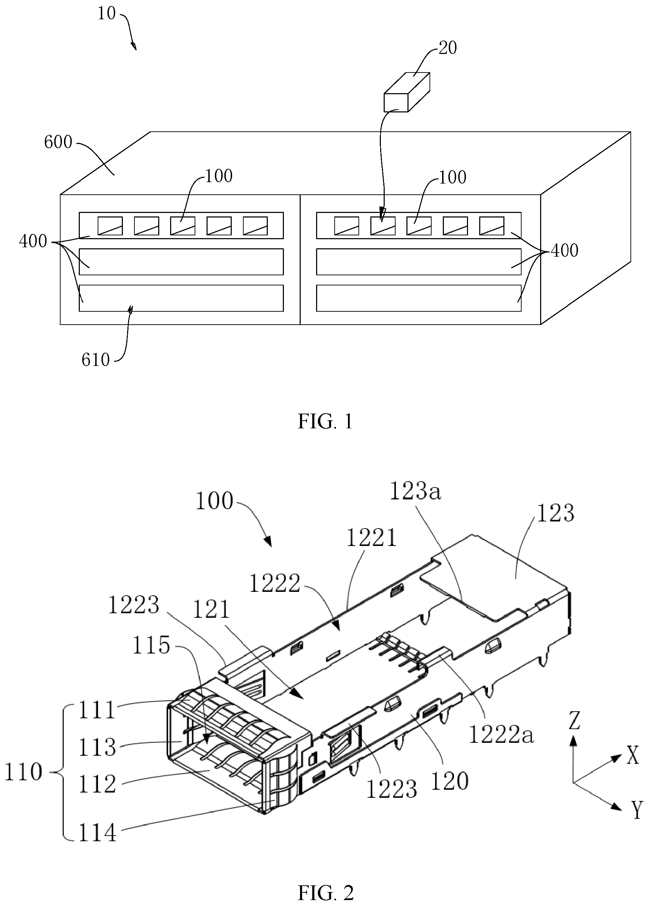

Communication technology has advantages such as high rates, long-distance transmission, and anti-interference, and is a mainstream technology in the communication field. The communication technology is widely used in communication devices such as switches, routers, and optical transmission devices. Refer to FIG. 1. A communication device 10 may include a sub-rack 600, circuit boards 400, optical cages 100, and optical modules 20. A mounting cavity 610 is provided on the sub-rack 600, and the circuit boards 400 are securely mounted within the mounting cavity 610. The circuit boards 400 are provided with the optical cages 100. The optical cage 100 has an optical module interface. The optical module interface is configured to allow assembly of the optical module 20. The optical module 20 is pluggably arranged on the interface of the optical cage 100. The optical module 20 may convert an electrical signal into an optical signal or convert an optical signal into an electrical signal. Signal connection is implemented between communication devices by using the optical module. A plurality of mounting cavities 610 may be provided in the communication device 10, and a plurality of circuit boards 400 are mounted in the plurality of mounting cavities 610. The plurality of circuit boards 400 may be vertically or horizontally distributed in the mounting cavities 610 along a thickness direction.

With the continuous development and upgrading of 4G and 5G networks, more optical cages are arranged in a communication device as optical modules are deployed more densely. Currently, an opening is formed in a part of the middle of the top of the optical cage, a boss of a heat sink is inserted into the opening on the top of the optical cage to be fastened to the optical cage, and the heat sink is in contact with the optical module through the boss and transfers heat. However, the heat sink is arranged on the top of the optical cage, and abuts against an upper cover of the optical cage, in which case the heat sink needs to be provided with a boss of a specific thickness to be inserted into the opening in the part of the middle of the top of the optical cage to be in contact with the optical module for heat dissipation. In such a stacking manner, the optical cages have a relatively large height when being stacked or a relatively large width when being horizontally arranged, resulting in an increased volume of the communication device. In view of this, realization of a high-integration optical cage layout within limited space becomes a problem that needs to be resolved, and the stacked design of heat sinks and optical cages requires optimization. In addition, a capacity of the optical module in the communication device continuously increases, and power consumption of the optical module greatly increases, requiring further improvement on a heat dissipation effect when the heat sink is in contact with the optical module through the boss and transfers heat.

This application provides an optical cage 100. An optical module 20 may be inserted into the optical cage 100. The optical cage 100 is configured to protect and secure the optical module 20. A shape of the optical cage 100 may be a rectangular columnar structure.

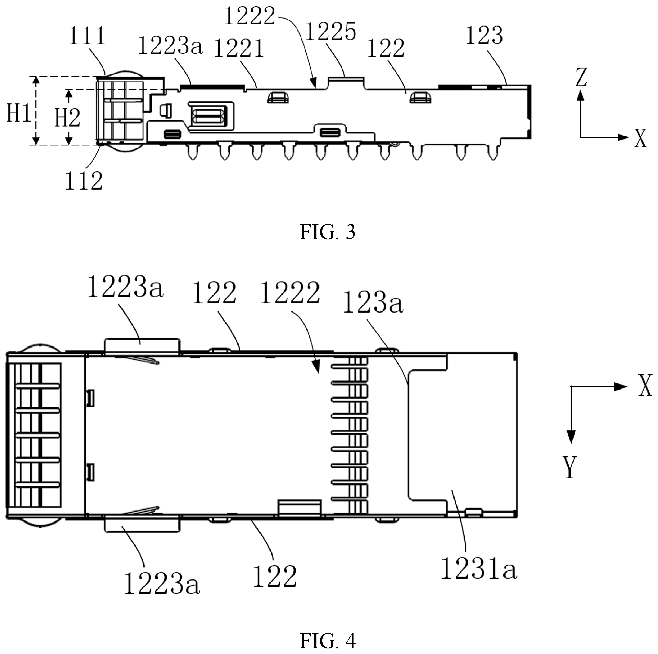

Refer to FIG. 2 to FIG. 4. FIG. 2 is a diagram of a structure of an optical cage according to this application. FIG. 3 is a side view of an optical cage 100 according to this application. FIG. 4 is a top view of an optical cage 100 according to this application.

The optical cage 100 includes an insertion portion 110 and an accommodating portion 120 that are adjoining each other along a first direction, where the first direction is an X direction in FIG. 2 (a first direction described below is also the X direction). The accommodating portion 120 is located on a side of the insertion portion 110 in the first direction. The insertion portion 110 includes a first insertion wall 111 and a second insertion wall 112 that are arranged opposite to each other, and further includes a third insertion wall 113 and a fourth insertion wall 114 that are arranged opposite to each other. The first insertion wall 111 and the second insertion wall 112 are arranged opposite to each other in a second direction, where the second direction is a Z direction in FIG. 2 (a second direction described below is also the Z direction). The first insertion wall 111, the third insertion wall 113, the second insertion wall 112, and the fourth insertion wall 114 are successively connected and cooperatively define a socket 115 that extends along the first direction, and the socket 115 is configured to receive the optical module 20. The optical module 20 is inserted into the accommodating portion 120 along the first direction. The insertion portion 110 and the accommodating portion 120 may be integrally formed, or may be detachably connected.

It may be understood that, in some other embodiments, the first insertion wall 111, the third insertion wall 113, the second insertion wall 112, and the fourth insertion wall 114 may be formed successively by bending the same piece of material. Alternatively, the first insertion wall 111, the third insertion wall 113, the second insertion wall 112, and the fourth insertion wall 114 may be formed by splicing together four independent structures. The third insertion wall 113 and the fourth insertion wall 114 may be of a plate-like structure, or may be of a hollowed-out mesh structure, or may be of a fence structure. This is not limited in this application. Alternatively, the third insertion wall 113 and the fourth insertion wall 114 may be connecting columns connected to two sides of the first insertion wall 111 and the second insertion wall 112. In this case, the connecting columns are fastened to the two sides of the first insertion wall 111 and the second insertion wall 112, so that the connecting columns are fastened to side spaces on the two sides of the first insertion wall 111 and the second insertion wall 112. The connecting columns have the same connection functions as the plate-like or hollowed-out mesh structure, and also fall within a structure scope of the insertion wall described in this application.

The accommodating portion 120 includes two side walls 122 that are arranged opposite to each other along a third direction, where the third direction is a Y direction in FIG. 2 (a third direction described below is also the Y direction). It should be noted that the side walls 122 refer to all side walls 122 of the accommodating portion 120 on a side in the third direction. The accommodating portion 120 on the side in the third direction may include one side wall 122, or may include a combination of two or more side walls 122. In this application, there are two side walls. An accommodating cavity 121 for accommodating the optical module is provided between the two side walls 122. The two side walls 122 are part of a wall surface of the accommodating cavity 121. The socket 115 and the accommodating cavity 121 are in communication with each other along the first direction, and the optical module is inserted into the accommodating cavity 121 through the socket 115 along the first direction, so that the optical module can be inserted into the optical cage 100.

First edges 1221 of the two side walls 122 along the second direction cooperatively define an opening 1222 of the accommodating cavity 121 on a side along the second direction, the first edges 1221 of the two side walls 122 along the second direction are parts of a side edge of the opening 1222, the opening 1222 and the accommodating cavity 121 are in communication with each other along the second direction, and the opening 1222 is a part of the accommodating cavity 121.

Refer to FIG. 3. Along the second direction, a height H2 of at least a part of the first edges 1221 is less than a height H1 of an outer wall surface of the first insertion wall 111. Along the second direction, at least a part of the first edges 1221 is located between the outer wall surface of the first insertion wall 111 and an outer wall surface of the second insertion wall 112. The outer wall surface of the first insertion wall 111 refers to an upper wall surface of the first insertion wall 111 along the second direction, and the outer wall surface of the second insertion wall 112 refers to a lower wall surface of the second insertion wall 112 opposite to the second direction. A position of the first edges 1221 in the second direction is lower than a position of the outer wall surface of the first insertion wall 111 in the second direction. An opening of the opening 1222 along the second direction is located on a side of the first insertion wall 111 opposite to the third direction (opposite to the Y direction in FIG. 2).

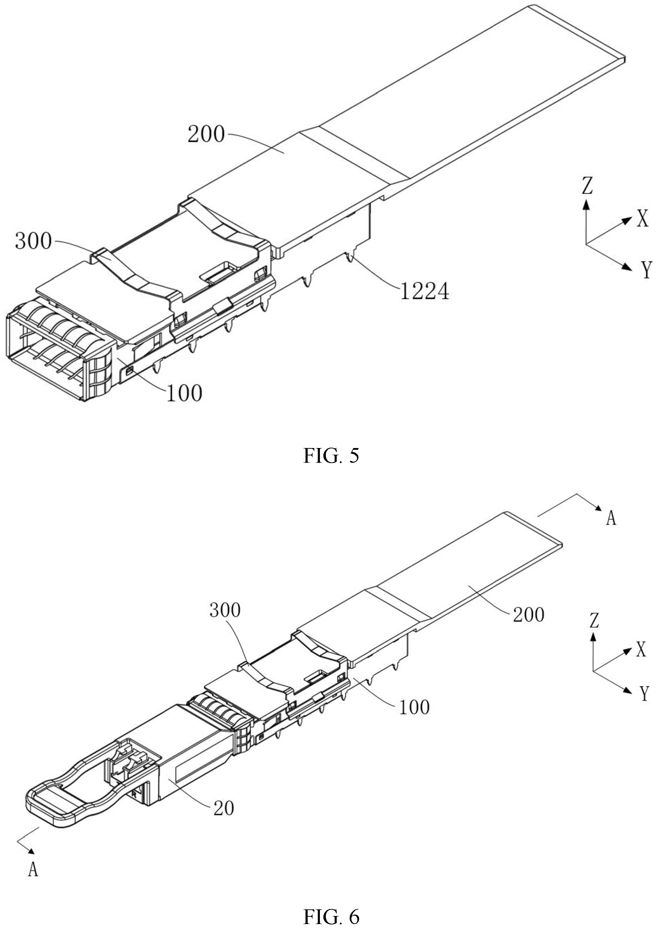

Refer to FIG. 5 and FIG. 6. FIG. 5 is a diagram of a structure of an optical cage 100 with a heat conduction apparatus 200 placed therein according to this application. The heat conduction apparatus 200 is arranged on a side of the optical cage 100 along a second direction (a Z direction in the figure), the heat conduction apparatus 200 may be arranged on two side walls 122, and cover an opening of the opening 1222 along the second direction, and first edges 1221 of the two side walls 122 are configured to be in contact with the heat conduction apparatus 200 to provide support. When an optical module 20 is inserted into the optical cage 100, the heat conduction apparatus 200 may dissipate heat for a side (the top of the optical module 20) that is of the optical module 20 and that is close to the heat conduction apparatus 200.

The heat conduction apparatus 200 may be of a step-like structure, where a thickness of a structure of the heat conduction apparatus 200 on a side close to an insertion portion 110 opposite to the second direction is less than a thickness of a structure of the heat conduction apparatus 200 on a side away from the insertion portion 110 opposite to the second direction. A side of the heat conduction apparatus 200 in contact with the opening 1222 of the optical cage 100 is of a planar structure.

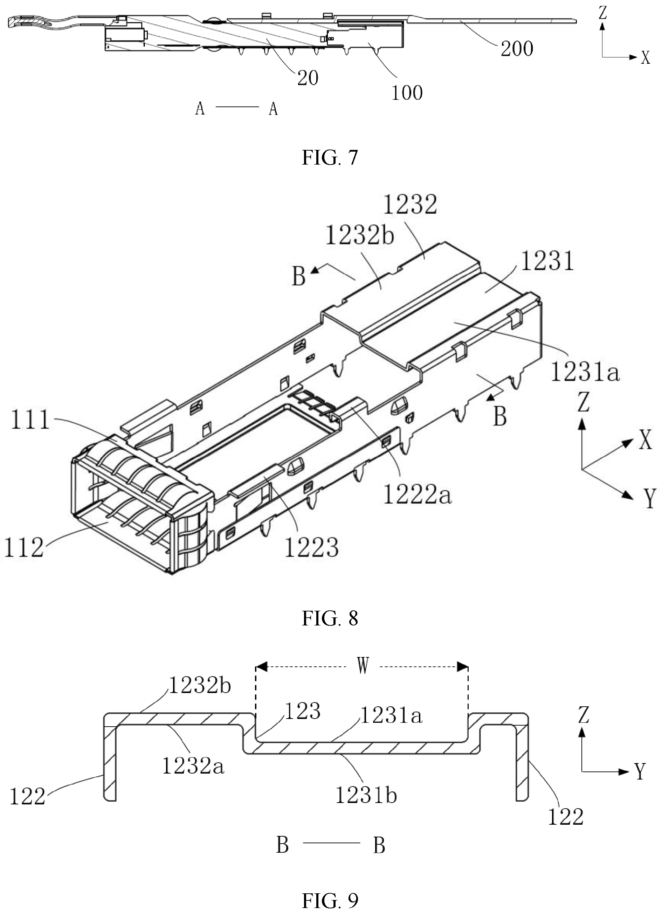

Refer to FIG. 3, FIG. 6, and FIG. 7. FIG. 6 is a diagram of a structure of an optical cage 100 with an optical module 20 inserted therein according to this application, and FIG. 7 is a cross-sectional view at A-A in FIG. 6. For example, in this application, the optical module 20 may be an optical module of a QSFP28 model. A difference between a height H1 of an insertion portion 110 of the optical cage 100 and a height H2 of a first edge 1221 in a second direction may be greater than 1 millimeter. For example, the height difference may be 1.25 millimeters. An upper limit of the difference between the height H1 and the height H2 may be designed based on structural strength of side walls 122 and a position of another structure on the side walls 122. Compared with the conventional technology in which a heat conduction apparatus is inserted into a through hole on the top of an optical cage 100 through a boss, this application reduces an overall height of the heat conduction apparatus 200 and the optical cage 100.

According to a heat conduction formula "Q=ΔT·λ·S/L", Q representing heat, ΔT representing a temperature difference, R representing thermal resistance, L representing a thickness, λ representing a heat conductivity coefficient, and S representing a heat transfer area, because the heat conduction apparatus 200 is directly in contact with the optical module 20, and a side of the heat conduction apparatus 200 in contact with the optical module 20 is of a planar structure, a contact area (that is, the heat transfer area S) is large, the thickness (L) of the heat conduction apparatus 200 is small, and a heat transfer path is shortened. Therefore, there is a large amount of heat transferred during heat exchange between the optical module 20 and the heat conduction apparatus 200, and more heat can be transferred from the optical module 20 to the heat conduction apparatus 200, thereby enhancing a heat conduction effect.

In the optical cage 100 provided in this application, the opening 1222 for allowing placement of the heat conduction apparatus 200 is provided at the accommodating portion 120 of the optical cage 100, and the height of the first edge 1221 of the opening 1222 is less than the height of the first insertion wall 111. When the heat conduction apparatus 200 is placed on the first edge 1221, because the height of the first edge 1221 is less than the height of the first insertion wall 111, the overall height of the heat conduction apparatus 200 and the optical cage 100 is reduced.

Particularly, for a high-capacity communication device in which optical modules 20 with high power consumption are densely arranged, a plurality of optical cages 100 are stacked, and a plurality of optical modules 20 are inserted into the optical cages 100. Due to a reduction in a height of a single optical cage 100, an overall height of the communication device is significantly reduced when the plurality of optical cages 100 are stacked, so that more optical modules 20 can be arranged within limited space, or the height of the communication device is reduced when the same quantity of optical modules 20 are arranged. In addition, the plurality of optical modules 20 generate more heat, but the optical modules 20 are directly in contact with the heat conduction apparatus 200, so that a heat dissipation effect is significantly improved, ensuring stable running of a system.

In a possible implementation, refer to FIG. 2 to FIG. 4. The accommodating portion 120 further includes a support plate 123. The first insertion wall 111, the opening 1222, and the support plate 123 are successively arranged. Specifically, the first insertion wall 111, the opening 1222, and the support plate 123 are successively arranged along the first direction, and the support plate 123 is located on a side that is of the accommodating portion 120 and that is away from the insertion portion 110.

A second edge 123a of the support plate 123 on a side close to the first insertion wall 111 is a part of the side edge of the opening 1222. The second edge 123a of the support plate 123 on the side close to the first insertion wall 111 and the first edges 1221 of the two side walls 122 along the second direction are components of the opening 1222. At least a part of an outer wall surface of the support plate 123 on a side in the second direction is a first wall surface 1231a. The first wall surface 1231a is configured to be in contact with the heat conduction apparatus 200 to provide support. Along the second direction, a height of the first wall surface 1231a is less than the height of the outer wall surface of the first insertion wall 111, and the first wall surface 1231a is located between the outer wall surface of the first insertion wall 111 and the outer wall surface of the second insertion wall 112. A position of the first wall surface 1231a along the second direction is lower than a position of the outer wall surface of the first insertion wall 111 along the second direction.

The support plate 123 is configured to support the heat conduction apparatus 200, and the first wall surface 1231a of the support plate 123 is in contact with the heat conduction apparatus 200 to support the heat conduction apparatus 200. The height of the first wall surface 1231a along the second direction is less than that of the outer wall surface of the first insertion wall 111, so that the overall height of the optical cage 100 and the heat conduction apparatus 200 is reduced while the heat conduction apparatus 200 can be supported.

In a possible implementation, an outer wall surface of the support plate 123 on the side in the second direction is a first wall surface 1231a, the first wall surface 1231a is parallel to the outer wall surface of the first insertion wall 111, and the first wall surface 1231a is configured to be in contact with the heat conduction apparatus 200 to provide support. Along the second direction, a height of the first wall surface 1231a is less than the height of the outer wall surface of the first insertion wall 111. The first wall surface 1231a is parallel to the outer wall surface of the first insertion wall 111, and along the second direction, the height of the first wall surface 1231a is less than the height of the outer wall surface of the first insertion wall 111, so that a height of the entire support plate 123 is less than the height of the outer wall surface of the first insertion wall 111. The support plate 123 can support the heat conduction apparatus 200. When the heat conduction apparatus 200 is mounted on the optical cage 100, the overall height of the heat conduction apparatus 200 and the optical cage 100 is reduced.

In a possible implementation, refer to FIG. 8 and FIG. 9. The support plate 123 includes a first portion 1231 and a second portion 1232 that are adjoining each other along the third direction. The first wall surface 1231a is an outer wall surface of the first portion 1231 along the second direction, an inner wall surface of the first portion 1231 on a side opposite to the second direction is a second wall surface 1231b, and an inner wall surface of the second portion 1232 on a side opposite to the second direction is a third wall surface 1232a. The third wall surface 1232a is located on a side of the second wall surface 1231b along the second direction to form a step structure.

In a possible implementation, refer to FIG. 8. An outer wall surface of the second portion 1232 on a side along the second direction is a fourth wall surface 1232b. The fourth wall surface 1232b is located on a side of the first wall surface 1231a along the second direction, and the second portion 1232 protrudes relative to the first portion 1231 along the second direction. There may be two second portions 1232 as shown in this implementation, and the two second portions 1232 are respectively located on two sides of the first portion 1231 along the third direction. Alternatively, there may be only one second portion 1232, and the second portion 1232 is arranged adjoining the first portion 1231 in the third direction. The support plate 123 may be formed by bending an integral plate, and a structure where the first portion 1231 is lower than the second portion 1232 is presented on an outer side. The first portion 1231 is located on a side of the second portion 1232 opposite to the second direction, to better mate with an optical module 20 of a QSFPDD model. In addition, a structure such as a heat pipe of the heat conduction apparatus may be arranged on a sunken part of the first portion 1231, to improve heat conduction efficiency of the heat conduction apparatus.

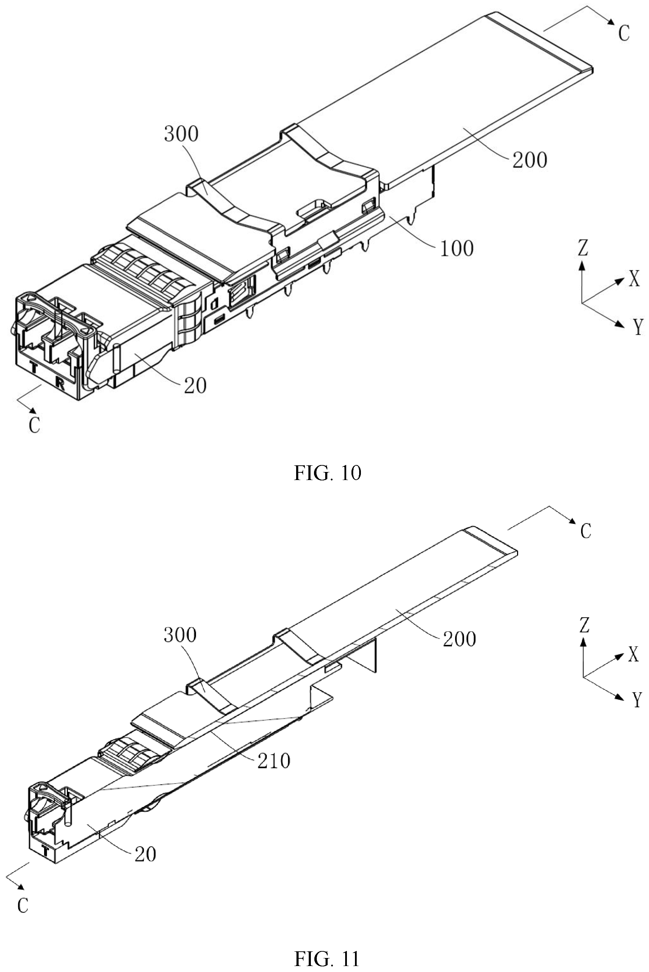

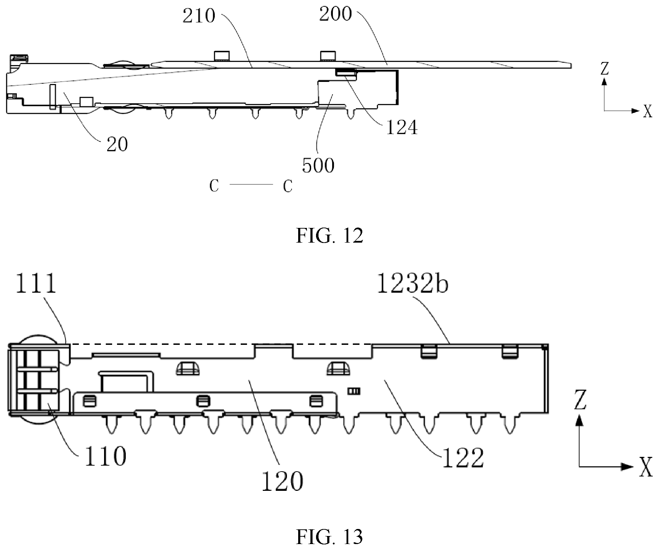

In a possible implementation, refer to FIG. 13. Along the second direction, the fourth wall surface 1232b is coplanar with the outer wall surface of the first insertion wall 111 along the second direction. To be specific, a plane where the fourth wall surface 1232b is located is coplanar with a plane where the outer wall surface of the first insertion wall 111 along the second direction is located. When an optical module of a QSFPDD model is inserted into the optical cage 100, because the optical module of the QSFPDD model is long, the fourth wall surface 1232b is coplanar with the outer wall surface of the first insertion wall 111 along the second direction, to ensure that the optical module of the QSFPDD model can be inserted into the optical cage 100. FIG. 10 is a diagram showing that an optical module of a QSFPDD model can be inserted into an optical cage 100.

In a possible implementation, refer to FIG. 9. A width W of the first wall surface 1231a along the third direction is greater than 7 millimeters. In an embodiment, the width of the first wall surface 1231a along the third direction is 8.5 millimeters. The heat conduction apparatus 200 may be provided with a heat pipe. A heat pipe may be fastened inside a heat conduction apparatus 200 through welding, to form the heat conduction apparatus including the heat pipe. A spacing between the first wall surface 1231a and the fourth wall surface 1232b along the second direction provides a space for arranging the heat pipe inside the heat conduction apparatus 200, so that a part of the heat conduction apparatus provided with the heat pipe inside can be placed. Arranging the heat pipe inside the heat conduction apparatus 200 can improve heat dissipation efficiency of the heat conduction apparatus 200, and bring a better heat dissipation effect for heat dissipation of the optical module 20.

In a possible implementation, refer to FIG. 12. The support plate 123 is provided with a wave-absorbing structure 124 on a side opposite to the second direction. The wave-absorbing structure 124 is configured to absorb electromagnetic radiation. The wave-absorbing structure 124 can absorb a radiated electromagnetic wave generated by an electromagnetic compatibility device, reduce electromagnetic interference, and prevent the radiated electromagnetic wave of the electromagnetic compatibility device from affecting a function of another communication device (which may be an optical module, a router, a switch, or the like in another optical cage within the same communication device). The wave-absorbing structure 124 may be attached to the side of the support plate 123 opposite to the second direction. The wave-absorbing structure 124 may be completely attached to the side of the support plate 123 opposite to the second direction, or may be merely partially attached to the side of the support plate 123 opposite to the second direction. A material for making the wave-absorbing structure 124 may include but is not limited to carbon fiber, polyphenylamine, and iron.

In a possible implementation, a thickness of the second edge 123a along the second direction ranges from 0.35 millimeters to 0.5 millimeters. When the optical module 20 is inserted into the optical cage 100, the second edge 123a (a wall surface of the support plate 123 on a side close to the opening 1222) can abut against the optical module 20. The thickness of the second edge 123a along the second direction ranges from 0.35 millimeters to 0.5 millimeters, so as to better abut against the optical module 20, limit the optical module 20, and ensure that the optical module and a connector can be accurately connected.

In an embodiment, the thickness of the second edge 123a of the support plate 123 along the second direction ranges from 0.35 millimeters to 0.5 millimeters, and thicknesses of remaining edges of the support plate 123 are all equal and less than the thickness of the second edge 123a along the second direction. That is, only an edge that is of the support plate 123 and that abuts against the optical module 20 is thickened. The second edge 123a limits the optical module 20.

In an embodiment, the thickness of the second edge 123a of the support plate 123 and thicknesses of other edges of the support plate 123 along the second direction all range from 0.35 millimeters to 0.5 millimeters. The thicknesses of all the side edges of the support plate 123 along the second direction are equal, to limit the optical module 20.

In a possible implementation, a first protrusion 1223 is arranged on at least one of the side walls 122, the first protrusion 1223 protrudes from the side wall 122 away from the accommodating cavity 121, the first protrusion 1223 has a support surface 1223a on a side along the second direction, and the support surface 1223a is configured to support the heat conduction apparatus 200.

In an embodiment, refer to FIG. 2 to FIG. 4. The two side walls 122 of the accommodating portion 120 are each provided with a first protrusion 1223 on a side in the second direction. The two first protrusions 1223 may be respectively integrated with the two side walls 122, or the two first protrusions 1223 may be respectively fastened to the two side walls 122 through welding or the like. The first protrusions 1223 on the side walls 122 protrude from the side wall 122 away from the accommodating cavity 121, and the first protrusions 1223 may extend along the second direction. The two first protrusions 1223 continue to be bent, in the third direction, respectively away from the two first protrusions 1223. A support surface 1223a is formed on a side of the first protrusion 1223 along the second direction. A plane where the support surface 1223a is located may be perpendicular to a plane where the side wall 122 is located. A width of the support surface 1223a along the third direction may be greater than a width of the first edges 1221 along the third direction, and the support surfaces 1223a can assist the two side walls 122 in supporting the heat conduction apparatus, to provide a larger support area for the heat conduction apparatus.

In a possible implementation, refer to FIG. 3. Along the second direction, a height of the support surface 1223a is less than the height of the outer wall surface of the first insertion wall 111, and the support surface 1223a is located between the outer wall surface of the first insertion wall 111 and the outer wall surface of the second insertion wall 112. The support surface 1223a not only can support the heat conduction apparatus 200, but also can ensure that the overall height of the heat conduction apparatus 200 and the optical cage 100 is reduced when the heat conduction apparatus 200 is mounted on the optical cage 100.

In a possible implementation, refer to FIG. 3. The side wall 122 is provided with a limiting structure 1225 on a side in the second direction, and a part of the limiting structure 1225 extends into the accommodating cavity 121 and is configured to abut against the optical module 20 along the first direction.

In an embodiment, refer to FIG. 3. The two side walls 122 of the accommodating portion 120 are each provided with a limiting structure 1225 on a side in the second direction. The two limiting structures 1225 may be respectively integrated with the two side walls 122, or the two limiting structures 1225 may be respectively fastened to the two side walls 122 through welding or the like. The limiting structure 1225 on each side wall 122 may partially extend into the accommodating cavity 121, and a part of the limiting structure 1225 extending into the accommodating cavity 121 is configured to abut against the optical module along the first direction, to limit an insertion depth of the optical module in the optical cage. A position to which the optical module is inserted into the optical cage along the first direction is limited, so that the optical module and the connector can be accurately connected.

In a possible implementation, the limiting structure 1225 includes a second protrusion 1222a extending from the first edge 1221 in the second direction, and a free end of the second protrusion 1222a is bent toward a side close to the accommodating cavity 121. Specifically, in an embodiment, refer to FIG. 2 and FIG. 3. The limiting structure 1225 includes a second protrusion 1222a extending from the first edge 1221 in the second direction, and a free end of the second protrusion 1222a is bent toward a side close to the accommodating cavity 121. The free end of the second protrusion 1222a may be of a structure in which the second protrusion 1222a is not connected to the first edge 1221. There may be two second protrusions 1222a. Free ends of the two second protrusions 1222a are both bent toward the side close to the accommodating cavity 121, to form C-like structures. The structure can mate with a groove on the optical module. When the optical module is inserted into the optical cage, the second protrusion 1222a may be inserted into the groove on the optical module, to limit the optical module and ensure an accurate insertion position of the optical module in the optical cage, thereby improving stability of a connection between the optical module and the optical cage.

In a possible implementation, a heat dissipation structure may be further arranged on a side of the heat conduction apparatus 200 in the second direction. For example, in embodiments, there may two heat dissipation structures. Certainly, in another embodiment, there may be only one heat dissipation structure or more than two heat dissipation structures. The heat dissipation structure may be made of metal (such as copper or aluminum), and the heat dissipation structure may be a heat dissipation fin. The heat dissipation fin can increase a heat dissipation area of the heat conduction apparatus 200, thereby improving heat dissipation efficiency of the heat conduction apparatus 200.

This application provides a communication device 10. The communication device 10 may include but is not limited to any communication device that needs to be connected to an optical module, such as a switch, a server, a router, an optical access product, an optical transmission device, and an optical transport device. For example, the communication device 10 in an implementation of this application may be a switch.

The communication device 10 may include a heat conduction apparatus 200 and the optical cage 100 according to any one of the foregoing implementations. The heat conduction apparatus 200 is arranged on an opening 1222 of the optical cage 100 on a side along a second direction, and covers the opening 1222. The heat conduction apparatus 200 is in contact with and connected to a first edge 1221 of the optical cage 100. A height of at least a part of the first edge 1221 in the second direction is less than a height of an outer wall surface of a first insertion wall 111. At least a part of the heat conduction apparatus 200 is located on a side of the outer wall surface of the first insertion wall 111 opposite to the second direction. After the heat conduction apparatus 200 is in contact with the first edge 1221, a side of the heat conduction apparatus 200 toward the opening 1222 is located on the side of the outer wall surface of the first insertion wall 111 opposite to the second direction.

The communication device 10 provided in this application is installed with the optical cage 100. The heat conduction apparatus 200 is in contact with the opening 1222 of the optical cage 100 when being mounted on the optical cage 100. The height of the first edge 1221 of the opening 1222 in the second direction is less than the height of the outer wall surface of the first insertion wall, so that an overall thickness of the optical cage 100 and the heat conduction apparatus 200 can be reduced. Especially when a plurality of optical cages 100 are arranged in the communication device 10, and a plurality of optical modules 20 are mounted in the optical cages 100 in one-to-one correspondence, an overall height of the communication device 10 provided with the plurality of optical cages 100 can be effectively reduced, and more optical cages can be arranged within limited space. In addition, the heat conduction apparatus 200 can be directly in contact with the optical module 20, thereby effectively improving a heat dissipation effect.

In a possible implementation, refer to FIG. 10 and FIG. 11. The communication device 10 further includes an elastic member 300. The elastic member 300 is configured to connect the optical cage 100 and the heat conduction apparatus 200, so as to apply, to the heat conduction apparatus 200, an elastic force toward a side of the optical cage 100 opposite to the second direction. Two ends of the elastic member 300 are connected to two side walls of the optical cage 100, and the elastic member 300 may fasten the heat conduction apparatus 200 onto the optical cage 100. The optical cage 100 is detachably connected to the heat conduction apparatus 200. Along the second direction, the heat conduction apparatus 200 moves relative to the optical cage 100. The heat conduction apparatus 200 may move up and down relative to the optical cage 100 in the second direction. The optical module 20 may be in contact with the side of the heat conduction apparatus 200 toward the opening 1222 when being inserted into the optical cage 100, and the heat conduction apparatus 200 moves toward the second direction, so that the heat conduction apparatus 200 is better attached to the optical module 20, thereby improving a heat dissipation effect.

When the optical module 20 is inserted into the optical cage 100, the elastic member 300 may apply an elastic force to the heat conduction apparatus 200 opposite to the second direction, so that the heat conduction apparatus 200 moves toward the side of the optical cage 100, thereby preventing the heat conduction apparatus 200 from excessively moving in the second direction. The elastic member 300 can limit the heat conduction apparatus 200 in the second direction, so as to ensure that the heat conduction apparatus 200 is preferably connected to the optical cage 100, and further preferably attached to the optical module 20, thereby improving the heat dissipation effect.

In a possible implementation, the communication device 10 further includes a circuit board 400. The optical cage 100 is fastened to the circuit board 400, and at least one optical cage 100 is mounted on the circuit board 400. At least one circuit board 400 is arranged in the communication device 10.

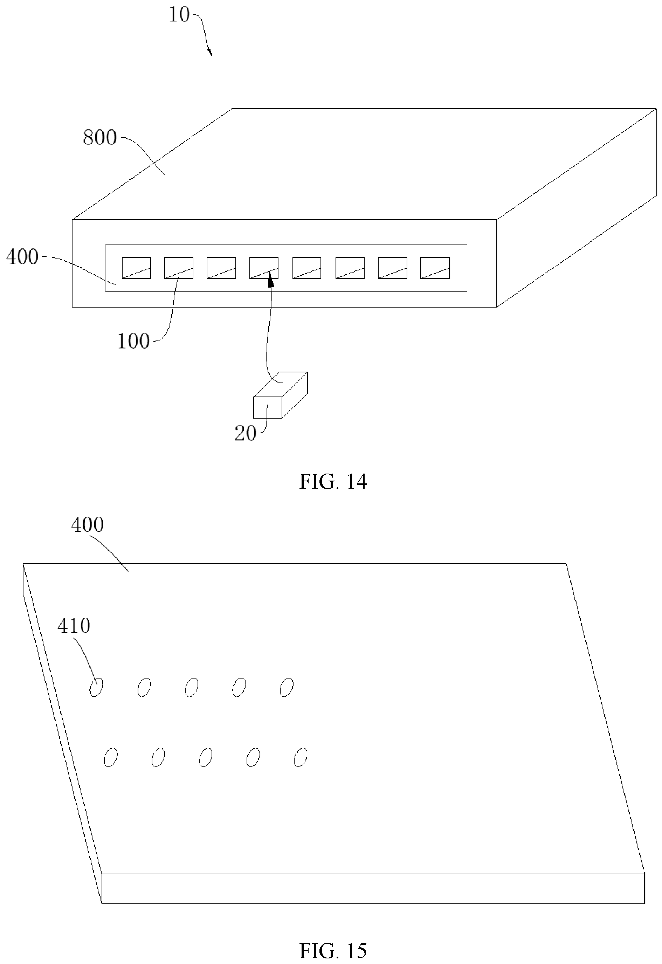

In an embodiment, refer to FIG. 14 and FIG. 15. A communication device 10 includes only one circuit board 400. The communication device 10 may include an enclosure 800, and the circuit board 400 is located within the enclosure 800. An optical cage 100 is mounted on the circuit board 400. Specifically, the optical cage 100 is provided with an insertion member 1224. The insertion member 1224 is located on a side of a side wall 122 opposite to a second direction, and the insertion member 1224 is arranged opposite to a mounting hole 410 on the circuit board 400. During assembly, an extrusion force is applied to the optical cage 100 opposite to the second direction, so that the insertion member 1224 is inserted into the mounting hole 410, and the optical cage 100 is mounted on the circuit board 400. FIG. 14 shows that eight optical cages 100 are mounted on the circuit board 400, heat conduction apparatuses 200 are mounted on a side of the optical cages 100 along the second direction, and optical modules 20 are inserted into the optical cages 100 in one-to-one correspondence. When the optical modules 20 operate, the heat conduction apparatuses 200 dissipate heat for the optical modules 20. It may be understood that the communication device 10 may be alternatively provided with a plurality of circuit boards 400, and a corresponding description is provided below.

In a possible implementation, refer to FIG. 12. The communication device 10 further includes a connector 500. The connector 500 is located within the optical cage 100, and each optical cage 100 is equipped with the connector 500. The connector 500 is electrically connected to the circuit board 400. The connector 500 is electrically connected to the circuit board 400 in a plurality of optional implementations. For example, the connector 500 and the circuit board 400 are connected through a pin-and-socket combination or by a flat cable. The connector 500 is configured to be electrically connected to the optical module 20. The optical module 20 is inserted into the optical cage 100 through an insertion portion 110 inside the communication device 10, and the optical module 20 is inserted into and connected to the connector 500 to implement an electrical connection. The heat conduction apparatus 200 is arranged on the top of the optical cage 100, to dissipate heat for the top of the optical module 20.

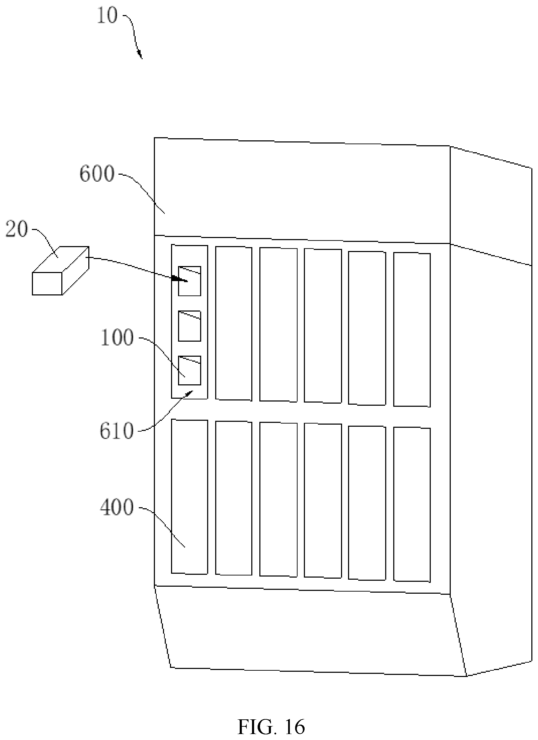

In a possible implementation, refer to FIG. 16. A communication device 10 includes a sub-rack 600, a mounting cavity 610 is provided on the sub-rack 600, and a circuit board 400 is securely mounted within the mounting cavity 610.

In an embodiment, there is at least one mounting cavity 610. A plurality of mounting cavities 610 may be provided within the sub-rack 600, and at least one circuit board 400 is arranged within a single mounting cavity. In this embodiment, FIG. 16 is used as an example for description. 12 mounting cavities 610 are provided on the sub-rack, a circuit board 400 is arranged within each mounting cavity 610, and the circuit board 400 is vertically placed inside the communication device 10. An optical cage 100 is arranged on each circuit board 400, and an optical module 20 is inserted into each optical cage 100. A heat conduction apparatus 200 is arranged on a side of the optical cage 100 along a third direction, and is in contact with an opening 1222 of the optical cage 100. A height of a first edge 1221 of the opening 1222 in the third direction is less than a height of an outer wall surface of a first insertion wall. When the heat conduction apparatus 200 is arranged on the optical cage 100, an overall thickness of the optical cage 100 and the heat conduction apparatus 200 can be reduced, and an overall width of the communication device 10 provided with a plurality of optical cages 100 is effectively reduced. In addition, the heat conduction apparatus 200 can be directly in contact with the optical module 20, thereby effectively improving a heat dissipation effect.

This application provides a heat conduction apparatus 200. Refer to FIG. 10, FIG. 11, and FIG. 12. The heat conduction apparatus 200 may be of a step-like structure, where a thickness of a structure of the heat conduction apparatus 200 on a side close to the insertion portion 110 opposite to the second direction is less than a thickness of a structure of the heat conduction apparatus 200 on a side away from the insertion portion 110 opposite to the second direction. That is, a thickness of a part of the heat conduction apparatus 200 in contact with the optical cage 100 is smaller opposite to the second direction. The heat conduction apparatus 200 has a heat conduction surface 210. The heat conduction surface 210 is of a planar structure, and the heat conduction surface 210 is configured to be in contact with the first edge 1221 of the optical cage 100 and the optical module 20. The heat conduction surface 210 is a surface of the heat conduction apparatus 200 that faces the optical cage 100 and that is in contact with the first edge 1221 of the optical cage 100 and the optical module 20. The heat conduction apparatus 200 performs heat exchange with the optical module 20 through the heat conduction surface 210, so as to achieve an effect of heat dissipation for the optical module 20. The heat conduction surface 210 may be directly in contact with the optical module, and a part of the heat conduction apparatus 200 in contact with the optical module 20 has a small thickness, which can better dissipate heat for the optical module and improve a heat dissipation effect.

The foregoing embodiments are merely used to describe the technical solutions of this application, and are not intended to limit this application. Although this application is described in detail with reference to the foregoing embodiments, a person of ordinary skill in the art should understand that modifications may still be made to the technical solutions described in the foregoing embodiments, or equivalent substitutions may be made to some of the technical features. However, these modifications or substitutions do not make the essence of the corresponding technical solution depart from the spirit and scope of the technical solutions of embodiments of this application, and shall all fall within the protection scope of this application.

## Claims

1. An optical cage, comprising an insertion portion and an accommodating portion that are adjoining each other along a first direction, wherein the insertion portion comprises a first insertion wall and a second insertion wall that are arranged opposite to each other, and further comprises a third insertion wall and a fourth insertion wall that are arranged opposite to each other, the first insertion wall is located on a side of the second insertion wall in a second direction, the first insertion wall, the third insertion wall, the second insertion wall, and the fourth insertion wall are successively connected and cooperatively define a socket that extends along the first direction, and the socket is configured to receive an optical module;
the accommodating portion comprises two side walls that are arranged opposite to each other along a third direction, an accommodating cavity for accommodating the optical module is provided between the two side walls, the socket and the accommodating cavity are in communication with each other along the first direction, first edges of the two side walls along the second direction cooperatively define an opening of the accommodating cavity on a side along the second direction, and the first edges are configured to be in contact with a heat conduction apparatus to provide support; and
along the second direction, a height of at least a part of the first edges is less than a height of an outer wall surface of the first insertion wall.

2. The optical cage according to claim 1, wherein the accommodating portion further comprises a support plate, the first insertion wall, the opening, and the support plate are successively arranged, and a second edge of the support plate on a side close to the first insertion wall is a part of a side edge of the opening; and
at least a part of an outer wall surface of the support plate on a side in the second direction is a first wall surface, the first wall surface is configured to be in contact with the heat conduction apparatus to provide support, and along the second direction, a height of the first wall surface is less than the height of the outer wall surface of the first insertion wall.

3. The optical cage according to claim 2, wherein the outer wall surface of the support plate on the side in the second direction is the first wall surface, the first wall surface is configured to be in contact with the heat conduction apparatus to provide support, and along the second direction, the height of the first wall surface is less than the height of the outer wall surface of the first insertion wall.

4. The optical cage according to claim 2, wherein the support plate comprises a first portion and a second portion that are adjoining each other along the third direction, the first wall surface is an outer wall surface of the first portion along the second direction, an inner wall surface of the first portion on a side opposite to the second direction is a second wall surface, an inner wall surface of the second portion on a side opposite to the second direction is a third wall surface, and the third wall surface is located on a side of the second wall surface along the second direction to form a step structure.

5. The optical cage according to claim 4, wherein an outer wall surface of the second portion on a side along the second direction is a fourth wall surface, the fourth wall surface is located on a side of the first wall surface along the second direction, and the second portion protrudes relative to the first portion along the second direction.

6. The optical cage according to claim 5, wherein along the second direction, the fourth wall surface is coplanar with the outer wall surface of the first insertion wall along the second direction.

7. The optical cage according to claim 5 or 6, wherein a width of the first wall surface along the third direction is greater than 7 millimeters.

8. The optical cage according to any one of claims 2 to 7, wherein the support plate is provided with a wave-absorbing structure on a side opposite to the second direction, and the wave-absorbing structure is configured to absorb electromagnetic radiation.

9. The optical cage according to any one of claims 2 to 8, wherein a thickness of the second edge along the second direction ranges from 0.35 millimeters to 0.5 millimeters.

10. The optical cage according to any one of claims 1 to 9, wherein a first protrusion is provided on at least one of the side walls, the first protrusion protrudes from the side wall away from the accommodating cavity, the first protrusion has a support surface on a side along the second direction, and the support surface is configured to support the heat conduction apparatus.

11. The optical cage according to claim 10, wherein along the second direction, a height of the support surface is less than the height of the outer wall surface of the first insertion wall.
